# EUROPÄISCHE PATENTANMELDUNG

(11) **EP 2 146 122 A1**
(43) Veröffentlichungstag der Anmeldung: **20.01.2010**
(21) Anmeldenummer: 08012989.3
(22) Anmeldetag: 18.07.2008
(51) Int. Cl.: F16K 3/314, F16K 51/02

(54) **Vakuumventil und Verschlussteller für ein Vakuumventil**

(71) Anmelder: VAT Holding AG, 9469 Haag (CH)
(72) Erfinder: Duelli, Bernhard, 6834 Übersaxen (AT)
(74) Vertreter: Harmann, Bernd-Günther

(57) **Zusammenfassung**

Die Erfindung betrifft ein Vakuumventil (1) zum gasdichten Schliessen eines Fliesswegs (F), mit mindestens einer Schubstange (7), die einen zylindrischen Verbindungsabschnitt (10) besitzt, und einem auf der Schubstange (7) abnehmbar montierten Verschlussteller (11), der mindestens eine mit dem Verbindungsabschnitt (10) korrespondierende, konkave, halbkreisförmige erste Stangenausnehmung (14) aufweist. Ein Klemmstück (17), das eine mit dem Verbindungsabschnitt (10) korrespondierende, konkave, halbkreisförmige zweite Stangenausnehmung (18) besitzt, ist mittels eines mechanischen Fixierungselements (19) auf dem Verschlussteller (11) derart verstellbar montiert, dass die halbkreisförmige erste Stangenausnehmung (14) und die gegenüberliegende halbkreisförmige zweite Stangenausnehmung (18) einen weitenverstellbaren zylindrischen Aufnahmebereich (20) definieren, in welchem der zylindrische Verbindungsabschnitt (10) lösbar aufgenommen ist. In der ersten oder zweiten Stangenausnehmung (14; 18) ist eine sich quer zur Schubstangenachse (8) erstreckende Aussparung (21) ausgeformt, in welcher sich ein elastischer Bolzen (22) quer zur Schubstangenachse (8) und tangential zum zylindrischen Aufnahmebereich (20) erstreckt, wobei der elastische Bolzen (22) in den zylindrischen Aufnahmebereich (20) hineinragt und in eine Fuge (16), die sich auf dem Verbindungsabschnitt (10) erstreckt, geklemmt ist, so dass die Schubstange (7) entlang der Schubstangenachse (8) fixiert ist.

## Beschreibung

Die Erfindung betrifft ein Vakuumventil zum gasdichten Schliessen eines Fliesswegs mit einem auf mindestens einer Schubstange abnehmbar montierten Verschlussteller nach dem Oberbegriff des Anspruchs 1 und einen Verschlussteller nach dem Oberbegriff des Anspruchs 12.

Vakuumventile zum im Wesentlichen gasdichten Schliessen eines Fliesswegs, der durch eine in einem Ventilgehäuse ausgeformte Öffnung führt, sind in unterschiedlichen Ausführungsformen aus dem Stand der Technik bekannt. Vakuumschieberventile kommen insbesondere im Bereich der IC- und Halbleiterfertigung, die in einer geschützten Atmosphäre möglichst ohne das Vorhandensein verunreinigender Partikel stattfinden muss, zum Einsatz. Beispielsweise durchlaufen in einer Fertigungsanlage für Halbleiter-Wafer oder Flüssigkristall-Substrate die hochsensiblen Halbleiter- oder Flüssigkristall-Elemente sequentiell mehrere Prozesskammern, in denen die innerhalb der Prozesskammer befindlichen Halbleiterelemente mittels jeweils einer Bearbeitungsvorrichtung bearbeitet werden. Sowohl während des Bearbeitungsprozesses innerhalb der Prozesskammer, als auch während des Transports von Prozesskammer zu Prozesskammer müssen sich die hochsensiblen Halbleiterelemente stets in geschützter Atmosphäre - insbesondere im Vakuum - befinden. Die Prozesskammern sind beispielsweise über Verbindungsgänge miteinander verbunden, wobei die Prozesskammern mittels Vakuumschieberventile zum Transfer der Teile von der einen zur nächsten Prozesskammer geöffnet und im Anschluss zur Durchführung des jeweiligen Fertigungsschritts gasdicht verschlossen werden können. Derartige Ventile werden aufgrund des beschriebenen Anwendungsgebiets auch als Vakuum-Transferventile und aufgrund ihres rechteckigen Öffnungsquerschnitts auch als Rechteckschieber bezeichnet.

Unterschiedliche Ausführungsformen von Vakuumventilen, insbesondere deren Dichtungs- und Antriebstechnologien, sind aus dem Stand der Technik bekannt. Abhängig von den jeweiligen Antriebstechnologien wird insbesondere zwischen Schieberventilen, auch Ventilschieber oder Rechteckschieber genannt, und Pendelventilen unterschieden, wobei das Schliessen und Öffnen im Stand der Technik meistens in zwei Schritten erfolgt. In einem ersten Schritt wird ein Ventilverschluss, insbesondere ein Verschlussteller, im Falle eines Schieberventils, wie beispielsweise aus der US 6,416,037 (Geiser) oder der US 6,056,266 (Blecha) bekannt, linear über eine Öffnung im Wesentlichen parallel zum Ventilsitz verschoben oder im Falle eines Pendelventils, wie beispielsweise aus der US 6,089,537 (Olmsted) bekannt, um eine Schwenkachse über die Öffnung geschwenkt, ohne dass hierbei eine Berührung zwischen dem Verschlussteller und dem Ventilsitz des Ventilgehäuses stattfindet. In einem zweiten Schritt wird der Verschlussteller mit dessen Verschlussseite auf den Ventilsitz des Ventilgehäuses gedrückt, so dass die Öffnung gasdicht verschlossen wird. Die Abdichtung kann z.B. entweder über einen auf der Verschlussseite des Verschlusstellers angeordneten Dichtungsring, der auf den die Öffnung umlaufenden Ventilsitz gepresst wird, erfolgen, oder über einen Dichtungsring auf dem Ventilsitz, gegen den die Verschlussseite des Verschlusstellers gedrückt wird. Der Dichtungsring kann in einer Nut gehalten und/oder aufvulkanisiert sein.

Ausserdem sind Schieberventile bekannt, bei welchen der Schliess- und Dichtvorgang über eine einzige lineare Bewegung erfolgt. Ein solches Ventil ist beispielsweise das unter der Produktbezeichnung "MONOVAT Reihe 02 und 03" bekannte und als Rechteckinsertventil ausgestaltete Transferventil der Firma VAT Vakuumventile AG in Haag, Schweiz. Der Aufbau und die Funktionsweise eines solchen Ventils werden beispielsweise in der US 4,809,950 (Geiser) und der US 4,881,717 (Geiser) beschrieben. Das dort beschriebene Ventil besitzt in seinem Gehäuse eine Dichtfläche, die, in Richtung der Achse der Ventildurchgangsöffnung gesehen, hintereinander liegende Abschnitte besitzt, die in seitlich nach aussen verlaufende, ebene Dichtflächenabschnitte über stetig verlaufende Krümmungen übergehen, wobei die gedachten Erzeugenden dieser einteiligen, aber mehrere Abschnitte aufweisenden Dichtfläche parallel zur Achse der Ventildurchgangsöffnung liegen. Die Dichtfläche ist bearbeitet. Das Verschlussglied besitzt eine dazu korrespondierende Auflagefläche für die umfangsgeschlossene Dichtung. Detaillierter beschrieben besitzt der so genannte Ventilschieber ein Schiebergehäuse und eine Schieberdurchgangsöffnung, die mit einem in seiner Ebene verschiebbaren Verschlussglied verschliessbar ist. Im Bereich der Schieberdurchgangsöffnung ist eine Dichtfläche vorgesehen, an der in der Schliessstellung des Verschlussgliedes eine an diesem angeordnete, umfangsgeschlossene Dichtung anliegt, wobei die gedachten, geraden Erzeugenden der Dichtfläche parallel zur Achse der Schieberdurchgangsöffnung liegen. Die umfangsgeschlossene, einstückige Dichtung weist Abschnitte unterschiedlicher Längen und/oder Formen auf, die in verschiedenen Ebenen liegen, wobei zwei Hauptabschnitte der umfangsgeschlossenen Dichtung in Ebenen liegen, welche zur Achse der Schieberdurchgangsöffnung rechtwinklig stehen und voneinander distanziert sind. Die beiden Hauptabschnitte der Dichtung sind durch Seitenabschnitte verbunden. Das Verschlussglied besitzt zum Verlauf der Dichtfläche des Gehäuses eine korrespondierend verlaufende, die umfangsgeschlossene Dichtung tragende Fläche. Die Seitenabschnitte der umfangsgeschlossenen Dichtung verlaufen U-förmig. Jeweils die Schenkel dieser U-förmig verlaufenden Seitenabschnitte liegen in einer Ebene. Die in Achsrichtung der Schieberdurchgangsöffnung gesehen hintereinander liegenden Abschnitte der Dichtfläche gehen für die Anlage der Hauptabschnitte der Dichtung in jenem Bereich, in dem sie eine gemeinsame, gerade, achsparallele Erzeugende besitzen, in seitlich nach aussen verlaufende ebene Dichtflächenabschnitte über. Diese ebenen Dichtflächenabschnitte liegen in zueinander und zur Achse der Schieberdurchgangsöffnung parallel liegenden Ebenen. Da das Verschlussglied einteilig ist, kann es hohen Beschleunigungskräften ausgesetzt werden, so dass dieses Ventil auch für Schnell- und Notverschlüsse verwendet werden kann. Da das Schliessen und Dichten mittels einer einzigen linearen Bewegung erfolgen kann, ist ein sehr schnelles Schliessen und Öffnen des Ventils möglich.

Ein geeigneter Antrieb für ein solches, mittels einer linearen Bewegung verschliessbares Transferventil ist in der JP 6241344 (Buriida Fuuberuto) dargestellt. Der dort beschriebene Antrieb besitzt exzentrisch gelagerte Hebel zum linearen Verschieben der Schubstangen, auf welchen das Verschlussglied montiert ist.

Da Transferventile unter anderem bei der Herstellung hochsensibler Halbleiterelemente zum Einsatz kommen, muss die insbesondere durch die Betätigung des Ventils verursachte Partikelgenerierung und die Anzahl der freien Partikel im Ventilraum möglichst gering gehalten werden. Die Partikelgenerierung ist primär eine Folge von Reibung beispielsweise durch Metall-Metall-Kontakt insbesondere zwischen dem Ventilverschluss und dem Ventilgehäuse oder dem Ventilsitz, und dem Ventilverschluss und den Schubstangen, auf welchen der Ventilverschluss befestigt und somit mit dem Antrieb verbunden ist.

Eine besondere Herausforderung zur Vermeidung der Partikelgenerierung ist die Verbindung zwischen den Schubstangen des Ventilantriebs und dem Ventilverschluss, insbesondere dem Verschlussteller.

Einerseits muss der Verschlussteller derart fest mit der Schubstange oder den Schubstangen verbunden sein, dass ein präzises Führen im Ventilgehäuse und ein genaues Andrücken des Verschlusstellers auf den Ventilsitz ohne ungewollte Materialberührungen bei gleichzeitig hoher Belastbarkeit des Verschlusstellers im geschlossenen Zustand des Ventils möglich ist. Ein ungewolltes relatives Bewegen des Verschlusstellers auf den Schubstangen kann aufgrund der dadurch verursachten Materialreibung zu einer Erzeugung von Reibpartikeln führen, welche die hochreine Atmosphäre im Ventilraum verunreinigen könnte. Daher wird im Stand der Technik meist ein spielfreier, fester Kontakt zwischen Schubstange und Verschlussteller angestrebt. Ziel ist eine möglichst parallele Ausrichtung der Verschlussfläche des Verschlusstellers zu dem Ventilsitz beim Aufdrücken des Verschlusstellers zur Ermöglichung eines gleichmässigen dichtenden Kontakts und zur Vermeidung eines allzu hohen Verschleisses - insbesondere des Dichtungselements. Anstelle einer festen, spielfreien und ausgerichteten Verbindung zwischen Schubstange und Verschlusstellers ist ebenfalls eine in einem begrenzten Bereich bewegliche Verbindung möglich, so dass die der Verschlussteller beim Aufdrücken selbst ausrichtet. Durch diese Selbstausrichtung kommt es jedoch beim Andrücken stets zu einer Relativbewegung zwischen Schubstange und Verschlussteller, wodurch verunreinigende Reibpartikel erzeugt werden.

Andererseits muss der Verschlussteller zur Wartung und/oder zum Austausch möglichst ohne grossen Demontageaufwand von der Schubstange abgenommen und wieder montiert werden können. Das somit erforderliche Schaffen einer ohne grossen Demontageaufwand lösbaren Verbindung steht jedoch in einem Zielkonflikt mit der gewünschten Vermeidung der Partikelgenerierung, da während der Demontage und Montage des Verschlusstellers von den Schubstangen eine reibende Materialberührung und die Erzeugung von Partikeln nur mit erheblichem Aufwand vermieden werden kann. Die Gefahr einer ungewollten relativen Bewegung zwischen dem Verschlussteller und den Schubstangen ist bei einer lösbaren Verbindung naturgemäss grösser als bei einer nichtlösbaren, insbesondere materialschlüssigen Verbindung.

Aus dem Stand der Technik ist bekannt, auf der Rückseite des Verschlusstellers eine oder zwei offene halbkreisförmige Ausnehmungen für zwei Schubstangen vorzusehen und die Schubstangen mittels jeweils einer Schraube, die durch jeweils eine Querbohrung in der Schubstange geführt wird und in eine in der Ausnehmung ausgebildete Gewindebohrung eingreift, zu montieren. Die in Bezug zu der Schubstange axiale Verbindung erfolgt sowohl reibschlüssig durch die über die Schraube aufgebrachte Kraft, die senkrecht zum Verschlussteller zwischen der Schubstange und der Ausnehmung wirkt, als auch formschlüssig über einen schulterartigen, nur in Schliessrichtung wirkenden Absatz in der Schubstange. Dieser Absatz stützt die Schubtange auf den oberen Rand der halbkreisförmigen Ausnehmung beim Schliessen des Verschlusstellers mittels der linearen Bewegung und Anpressen des Verschlusstellers auf den Ventilsitz ab.

Eine solche Befestigung wird beispielsweise bei dem unter der Produktbezeichnung "MONOVAT Reihe 02 und 03" bekannten und als Rechteckinsertventil ausgestalteten Transferventil der Firma VAT Vakuumventile AG in Haag, Schweiz, verwendet. Um ein exaktes Ausrichten des Verschlusstellers zum Ventilsitz zu ermöglichen, werden die Schrauben nach der Montage des Verschlusstellers zunächst nicht fest angezogen, so dass eine Relativbewegung zwischen den Schubstangen und dem Verschlussteller durch Überwindung der Reibung bei Schliessen des Ventils noch möglich ist. Im Anschluss wird das Ventil geschlossen. Der Ventilteller richtet sich aufgrund der noch nicht ganz fixierten Befestigung zwischen den Schubstangen und dem Verschlussteller exakt auf den Ventilsitz aus. Ausserdem verschieben sich die entlang des linearen Verstellwegs zunächst reibschlüssig gehaltenen Schubstangen relativ zum Verschlussteller, bis der schulterartige Absatz fest auf dem oberen Rand der halbkreisförmigen Ausnehmung zum Liegen kommt und somit der Schliesskraftfluss über Formschluss erfolgt. In einem nächsten Schritt werden die Schrauben derart fest angezogen, dass ein relatives Bewegen des Verschlusstellers gegenüber den Schubstangen nicht mehr möglich ist. Die beiden schulterartigen Absätze der beiden Schubstangen liegen fest auf den oberen Rändern der halbkreisförmigen Ausnehmungen auf und werden dort reibschlüssig durch Anziehen der Schrauben fixiert. Da lediglich in der linearen Schliessrichtung eine grosse Kraft auf die Verbindungen zwischen den Schubstangen und dem Verschlussteller wirkt und diese grosse Kraft formschlüssig über die schulterartigen Absätze aufgefangen wird, kommt es nach dem festen Anziehen der Schrauben zu keinen wesentlichen Verschiebungen zwischen den Schubstangen und dem Verschlussteller, so dass die Erzeugung von Materialpartikeln durch Reibung im normalen Betrieb des Vakuumventils relativ gering gehalten wird. Die vor dem festen Anziehen der Schrauben durch das Ausrichten auf den Schubstangen erzeugten Partikel werden mittels Reinigung entfernt. Aufgrund der Fixierung des Verschlusstellers auf den Schubstangen werden bis zum erneuten Lösen der Schrauben kaum weitere Partikel erzeugt.

Ein Nachteil der bekannten Verbindung zwischen dem Verschlussteller und der Schubstange ist der mit dem Lösen und Anziehen der Schrauben verbundene, relativ grosse Zeitaufwand bei der Demontage und Montage des Verschlusstellers von bzw. auf die Schubstangen. Ohne Einsetzen der Schrauben wird der Verschlussteller nicht auf der Schubstange gehalten. Im Falle zweier Schubstangen muss der Verschlussteller daher solange manuell gehalten werden, bis beide Schrauben in die Gewinde eingeführt sind. Umgekehrtes gilt für die Demontage. Das oben beschriebene zweitstufige Festziehen der Schrauben zum exakten Ausrichten des Verschlusstellers ist ein Problem, das durch die bisher bekannten Verbindungen nicht hinreichend gelöst werden konnte. Ein schneller und komfortabler bedienbares Verbindungselement, mittels welchem der Verschlussteller bereits nach der möglichst einfach zu erfolgenden Montage und noch vor dem ersten Verschliessen des Ventils reaktiv exakt auf der Schubstange ausgerichtet ist, wäre wünschenswert, um unmittelbar nach der Montage des Verschlusstellers auf den Schubstangen Materialreibungen und die Erzeugung von Partikeln verhindern zu können.

Es ist daher Aufgabe der Erfindung, einen Verschlussteller eines Vakuumventils zur Verfügung zu stellen, der ohne grossen Montageaufwand innerhalb kurzer Zeit auf der mindestens einen Schubstange des Ventilantriebs möglichst exakt und selbstausrichtend montierbar und wieder demontierbar ist, wobei die während des Betriebs des Vakuumventils verursachte Existenz freier Materialpartikel innerhalb des Ventilraums gering gehalten wird.

Diese Aufgabe wird durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen zu entnehmen.

Das im Rahmen der Erfindung umfasste Vakuumventil dient zum gasdichten Schliessen eines Fliesswegs, wobei unter dem Fliessweg allgemein ein zu schliessender Öffnungspfad zwischen zwei Bereichen - insbesondere zwischen einer Prozesskammer zur Halbleiterfertigung und entweder einer weiteren Prozesskammer oder der Aussenwelt - zu verstehen ist. Der Fliessweg ist beispielsweise ein Verbindungsgang zwischen zwei miteinander verbundenen Prozesskammern, wobei die Prozesskammern mittels des Vakuumventils zum Transfer der Halbleiterteile von der einen zur nächsten Prozesskammer geöffnet und im Anschluss zur Durchführung des jeweiligen Fertigungsschritts gasdicht verschlossen werden können. Derartige Ventile werden aufgrund des beschriebenen Anwendungsgebiets auch als Vakuum-Transferventile und aufgrund ihres meist rechteckigen Öffnungsquerschnitts auch als Rechteckschieber bezeichnet. Selbstverständlich ist jedoch auch jede beliebige andere Anwendung des erfindungsgemässen Vakuumventils zum im Wesentlichen gasdichten Schliessen eines beliebigen Fliesswegs zu verstehen. Das Vakuumventil umfasst ein Ventilgehäuse mit einer Öffnung für den Fliessweg. Die Öffnung ist beispielsweise rechteckig ausgebildet und hat eine Mittelachse, die sich im Bereich der Öffnung in der Mitte des Fliesswegs parallel zu diesem erstreckt. Diese Öffnungsachse steht beispielsweise senkrecht auf der von der Öffnung aufgespannten Fläche. Die Öffnung wird von einer Ventilsitzfläche umschlossen, die sich um die Öffnung erstreckt.

Ausserdem weist das Vakuumventil mindestens eine Schubstange - vorzugsweise zwei Schubstangen - auf. Auf der mindestens einen Schubstange ist ein Verschlussteller abnehmbar montiert. Die mindestens eine Schubstange ist über einen Ventilantrieb entlang ihrer Schubstangenachse, die im Wesentlichen quer zur Öffnungsachse, also in einer sich senkrecht zu der Öffnungsachse ersteckenden gedachten Ebene, der Verschlusstellerebene, verläuft, im Wesentlichen linear verstellbar. Die Schubstangenachse ist insbesondere parallel oder kollinear zu der Mittelachse der vorzugsweise geraden Schubstange. Die von dem Verschlussteller definierte Verschlusstellerebene ist vorzugsweise im Wesentlichen parallel zu der von der Öffnung aufgespannten Fläche. Der Ventilantrieb wird beispielsweise von einem aus dem Stand der Technik bekannten Ventilantrieb gebildet. Ein geeigneter Antrieb für ein mittels einer einzigen linearen Bewegung verschliessbares Vakuumventil ist in der JP 6241344 (Buriida Fuuberuto) dargestellt. Der dort beschriebene Ventilantrieb besitzt exzentrisch gelagerte Hebel zum linearen Verschieben der Schubstangen. Bei einem derartigen Antrieb und einem derartigen Verschlussteller wirkt die Schliesskraft im Wesentlichen axial der Schubstange, so dass das Schliessen des Vakuumventils zu keiner seitlich auf die Schubstange wirkenden Kraft führt. Erst eine Druckdifferenz im Fliessweg ruft eine Seitenkraft hervor, wobei eine Durchbiegung der Schubstange durch ein Abstützen des Verschlusstellers am Ventilgehäuse vermieden werden kann.

Alternativ ist der Ventilantrieb derart beschaffen, dass das Schliessen und Öffnen in zwei Schritten erfolgt. In einem ersten Schritt wird der Verschlussteller linear entlang der Schubstangenachse über eine Öffnung im Wesentlichen parallel zum Ventilsitz verschoben. In einem zweiten Schritt wird der Verschlussteller mit dessen Verschlussseite auf den Ventilsitz des Ventilgehäuses gedrückt, so dass die Öffnung gasdicht verschlossen wird. Hierbei kommt es, abhängig von der Ausgestaltung des Antriebs, zu einer erheblichen, seitlich auf die Schubstange wirkenden Kraft, weshalb die Schubstange eine entsprechend steife Dimensionierung zur Vermeidung einer allzu grossen Durchbiegung aufweisen muss.

Am Ende der Schubstange, also am Schubstangenende, ist ein zylindrischer Verbindungsabschnitt ausgeformt. Der Verbindungsabschnitt hat vorzugsweise in der Ebene senkrecht zur Schubstangenachse einen kreisrunden Querschnitt, der entlang der Schubstangenachse im Bereich des wirkenden Verbindungsabschnitts im Wesentlichen konstant ist.

Der auf der mindestens einen Schubstange abnehmbar montierte Verschlussteller hat eine Verschlussseite und eine hierzu im Wesentlichen parallel gegenüberliegende Rückseite, so dass die Verschlussseite und die Rückseite in entgegen gesetzte Richtungen weisen. In einer Ausführungsform verläuft die Verschlusstellerebene mittig und parallel zwischen den Ebenen der Verschlussseite und der Rückseite.

Ausserdem besitzt der Verschlussteller eine mit der Ventilsitzfläche korrespondierende Verschlussfläche. Unter korrespondierend ist zu verstehen, dass die Verschlussfläche und die Ventilsitzfläche derart geformt sind, dass der Verschlussteller mit seiner Verschlussfläche derart auf den Ventilsitz gedrückt werden kann, dass um die Öffnung herum ein dichtender Kontakt zwischen der Verschlussfläche und der Ventilsitzfläche hergestellt werden kann. Durch Herstellen des dichtenden Kontakts zwischen der Verschlussfläche und der Ventilsitzfläche mittels des Ventilantriebs wird der Fliessweg und somit die Öffnung gasdicht geschlossen, wobei der Verschlussteller mit seiner Verschlussseite auf die Öffnung weist und die Rückseite von der Öffnung weggewandt ist. Abhängig von der Ausgestaltung des Ventilsitzes und des Ventiltyps kann die Verschlussfläche entweder zu der Seite, in welche auch die Schubstangenachsen zeigen, oder zu der Verschlussseite weisen. Im Folgenden wird detaillierter auf den Aufbau der Verschlussfläche eingegangen.

Entweder auf der Verschlussseite oder auf der Rückseite des Verschlusstellers ist, entsprechend der Anzahl der Schubstangen, mindestens eine mit dem Verbindungsabschnitt der Schubstange korrespondierende, konkave, halbkreisförmige erste Stangenausnehmung am Verschlussteller ausgeformt. Diejenige Seite am Verschlussteller, auf welcher die erste Stangenausnehmung ausgeformt ist, wird im Folgenden die Befestigungsseite genannt. Die erste Stangenausnehmung korrespondiert derart mit dem Verbindungsabschnitt der Schubstange, dass es möglich ist, den Verbindungsabschnitt mit der ersten Stangenausnehmung zu koppeln. Die erste Stangenausnehmung weist insbesondere eine halbrunde Rinnenform, also eine Halbzylinderschalenform auf, in welcher der insbesondere zylindrische, in die Rinnenform passende Verbindungsabschnitt angeordnet werden kann.

Insbesondere sind zwei Schubstangen und zwei erste Stangenausnehmungen vorgesehen, die in der Verschlusstellerebene parallel verlaufend angeordnet sind.

Der jeweilige Verbindungsabschnitt der mindestens einen Schubstange ist in der ersten Stangenausnehmung lösbar mittels Befestigungsmittel fixiert.

Die Befestigungsmittel sind als ein Klemmstück und ein mechanisches Fixierungselement, beispielsweise mindestens eine Schraube, ausgebildet. Das Klemmstück besitzt eine mit dem Verbindungsabschnitt korrespondierende, konkave, halbkreisförmige zweite Stangenausnehmung. Die zweite Stangenausnehmung hat insbesondere ebenfalls eine halbrunde Rinnenform, also eine Halbzylinderschalenförm.

Mittels des mechanischen Fixierungselements ist das Klemmstück auf der Befestigungsseite des Verschlusstellers derart verstellbar montiert, dass die halbkreisförmige erste Stangenausnehmung und die gegenüberliegende halbkreisförmige zweite Stangenausnehmung einen weitenverstellbaren zylindrischen Aufnahmebereich definieren. In diesen Aufnahmebereich ist der zylindrische Verbindungsabschnitt im montierten Zustand des Verschlusstellers auf der Schubstange lösbar aufgenommen. Die Schubstange ist mit ihrem Verbindungsabschnitt in den Aufnahmebereich in Schubstangenrichtung einführbar und in entgegen gesetzter Richtung wieder ausführbar.

In anderen Worten befinden sich die halbkreisförmige erste Stangenausnehmung des Verschlusstellers und die halbkreisförmige zweite Stangenausnehmung des Klemmstücks in Gegenüberlage. Somit bilden die Stangenausnehmungen im Wesentlichen zwei mehr oder weniger vollständige Halbzylinderschalen des zylindrischen Aufnahmebereichs. Die Weitenverstellbarkeit wird dadurch erreicht, dass das Klemmstück und somit die zweite Stangenausnehmung relativ zur Befestigungsseite des Verschlusstellers und somit zur ersten Stangenausnehmung in im Wesentlichen senkrechter Richtung zur Befestigungsseite und zur Verschlusstellerebenen verstellbar ist. Der Abstand zwischen der ersten Stangeausnehmung und der zweiten Stangenausnehmung ist also in Richtung senkrecht zur Verschlusstellerebenen mittels des mechanischen Fixierungselements variierbar. Da die Form des Aufnahmebereichs in gewissem Masse abhängig ist von der momentanen Einstellung des Klemmstücks und dem Abstand der Stangenausnehmungen, ist die Form des Aufnahmebereichs nicht genau oder nur bei einem bestimmten Abstand zylindrisch und ist insbesondere unterbrochen durch eine Fuge zwischen dem Klemmstück und dem Verschlussteller. Ebenfalls kann die Form der halbkreisförmigen Stangenausnehmungen von der halbkreisförmigen, also der Halbzylinderschalenform abweichen. Die Form der ersten Stangenausnehmung und der zweiten Stangenausnehmung ist daher allgemein derart zu verstehen, dass der aufgespannte Aufnahmebereich zur Aufnahme des zylindrischen Verbindungsabschnitts der Schubstange geeignet ist und diesen durch Verringern des Abstandes der beiden Stangenausnehmungen in Schubstangenachse relativ zum Verschlussteller zu fixieren vermag. Selbstverständlich ist es möglich, dass die Halbkreisform, also die halbzylindrische Kontur der Stangenausnehmungen, durch Absätze, Nuten oder Wülste sowohl in Richtung der Schubstangenachse als auch quer zu dieser unterbrochen ist.

In der ersten Stangenausnehmung oder der zweiten Stangenausnehmung ist eine sich quer zur Schubstangenachse - also in einer Ebene senkrecht zur Schubstangenachse - erstreckende Aussparung ausgeformt, in welcher sich ein elastischer Bolzen quer zur Schubstangenachse - also in einer Ebene senkrecht zur Schubstangenachse - und tangential zum zylindrischen Aufnahmebereich erstreckt, wobei der elastische Bolzen mit seiner Seitenfläche in den zylindrischen Aufnahmebereich hineinragt. In anderen Worten bildet der Bolzen eine Sekante des im Wesentlichen kreisrunden Querschnitts des Aufnahmebereichs.

Vorzugsweise sind beide Enden des Bolzens in der Aussparung fixiert, wobei der mittlere unfixierte Bereich des Bolzens zwischen den beiden Enden zum einen Teil sich in der Aussparung erstreckt und zum anderen Teil in den zylindrischen Aufnahmebereich hineinragt. Da sich der mittlere Bereich des Bolzens frei erstreckt und unfixiert ist, ist er senkrecht zu seiner Längserstreckung elastisch und biegt sich bei einer Kraftausübung, welche in radialer Richtung des zylindrischen Aufnahmebereichs nach Aussen auf die Seitenfläche des Bolzens in dessen mittleren Bereich wirkt, zwischen seinen Enden durch. Dieses Durchbiegen bildet die Elastizität des Bolzens. Der längliche Bolzen kann eine kreiszylindrische Form mit einen kreisrunden Querschnitt haben, oder einen elliptischen, rechteckigen, quadratischen, polygonalen oder sonstigen Querschnitt besitzen. Die Mantelfläche des allgemeinen Zylinders bildet die Seitenfläche des Bolzens.

Alternativ ist es möglich, dass nur ein Ende des Bolzens in der Aussparung fixiert ist und das andere frei beweglich ist, wodurch sich die Elastizität des Bolzens vergrössert.

Der Verbindungsabschnitt der Schubstange besitzt eine quer zur Schubstangenachse verlaufende, mit dem Bolzen korrespondierende Fuge. Die Fuge erstreckt sich entweder rings um den gesamten Verbindungsabschnitt der Schubstange oder nur teilweise um den Verbindungsabschnitt, oder ist seitlich in Form einer Einkerbung ausbildet. Vorzugsweise erstreckt sich die Fuge auf einer Ebene, zu welcher die Schubstangenachse eine Normale bildet, also einer Ebene senkrecht zur Schubstangenachse.

Die Fuge erstreckt sich derart, dass - im montierten Zustand des Verschlusstellers auf der Schubstange, in welchem der Verbindungsabschnitt in den Aufnahmebereich eingeführt ist - der Bolzen mit seiner Seitenfläche mittels des Klemmstücks und des Fixierungselements in die Fuge geklemmt ist. Somit fixiert der Bolzen die Schubstange entlang der Schubstangenachse. Verläuft die Fuge nur teilweise um den Verbindungsabschnitt, so ist die Fuge auf der zum Bolzen weisenden Seite des Verbindungsabschnitts ausgeformt.

Die Fuge hat insbesondere einen im Wesentlichen V-förmig nach innen in die Fuge verjüngenden Querschnitt, einen halbkreisförmigen Querschnitt oder einen sonstigen Querschnitt.

Durch den in den Aufnahmebereich tangential hineinragenden Bolzen wird eine elastische Engstelle im Aufnahmebereich geschaffen. Zum Montieren des Verschlusstellers wird die Weite des Aufnahmebereichs, also der Abstand der Stangenausnehmungen, derart eingestellt, dass der Verbindungsabschnitt mit einem gewissen radialen Spiel, also mit Spielpassung, in den Aufnahmebereich eingeführt werden kann. Beim Aufsetzen des Verschlusstellers auf die mindestens eine Schubstange und somit bei Einführen des Verbindungsabschnitts in den Aufnahmebereich wird der die Engstelle bildende Bolzen zunächst elastisch verformt, indem sich der Bolzen durchbiegt und in die Aussparung gedrängt wird. Ist der Verschlussteller vollständig aufgesetzt, so dass der Verbindungsabschnitt vollständig in den Aufnahmebereich eingeführt ist, befinden sich der Bolzen und die Fuge auf gleicher Höhe, so dass sich der durchgebogene Bolzen teilweise entspannt, aus der Aussparung hervortritt und sich in Fuge schmiegt. Durch dieses Klemmen des Bolzens in die Fuge wird der Verschlussteller in Richtung der Schubstangenachse teilweise formschlüssige axial fixiert und axial gehalten, so dass insbesondere bei nach unten weisenden Schubstangen ein Herabrutschen des Verschlusstellers vermieden wird, ohne dass ein Verstellen der Weite des Aufnahmebereichs erforderlich ist. Somit ist der Verschlussteller bereits ohne mechanisches Verstellen des Fixierungselements teilweise fixiert.

In diesem teilweise fixierten Zustand kann nun ein Feinausrichten des Verschlusstellers auf der Schubstange durch Schliessen des Ventils und Aufdrücken des Verschlusstellers auf den Ventilsitz erfolgen. Hierbei richtet sich die Verschlussfläche zur Ventilsitzfläche exakt aus und der Verschlussteller nimmt die gewünschte Position auf der mindestens einen Schubstange ein. In diesem hochpräzise ausgerichteten Zustand kann nun das Klemmstück mittels des Fixierungselements verstellt und Öffnungsweite des Aufnahmebereichs derart reduziert werden, dass die beiden gegenüberliegenden Stangenausnehmungen den dazwischen liegenden Verbindungsabschnitt der Schubstange einklemmen und reibschlüssig fixieren. Hierbei wird der durchgebogenen Bolzen doch weiter verformt und noch fester in die Fuge geklemmt, wodurch die axiale Fixierung des Verschlusstellers auf der Schubstange erhöht wird.

Durch die einfache Ausrichtbarkeit des Verschlusstellers auf der Schubstange, der nur zum endgültigen Fixieren erforderlichen Verstellung des Fixierungselements und der sowohl formschlüssigen wie auch reibschlüssige axialen Fixierung ist ein schnelles und einfaches Montieren und Demontieren des Verschlusstellers auf bzw. von der mindestens einen Schubstange möglich. Weiters wird die Partikelgenerierung aufgrund des Vermeidens mehrfachen Verstellens des Fixierungselements, der axialen formschlüssigen Vorfixierung und der zusätzlichen formschlüssigen axialen Endfixierung gering gehalten.

Das erfindungsgemässe Vakuumventil und der erfindungsgemässe Verschlussteller werden nachfolgend anhand von in den Zeichnungen schematisch dargestellten konkreten Ausführungsbeispielen rein beispielhaft näher beschrieben.

Im Einzelnen zeigen
- Fig. 1: eine Schrägansicht auf ein Vakuumventil mit einem Verschlussteller in geschlossener Position und einem Ventilantrieb;
- Fig. 2: eine Frontansicht auf das Vakuumventil aus Fig. 1 mit dem Verschlussteller in geöffneter Position ohne Ventilantrieb;
- Fig. 3a: einen Querschnitt des Verschlusstellers und der Schubstange in Schrägansicht;
- Fig. 3b: eine Querschnittsansicht des Verschlusstellers und der Schubstange;
- Fig. 4: eine Detailansicht auf das Klemmstück;
- Fig. 5: eine Querschnittsansicht des Klemmstücks;
- Fig. 6a: eine Draufsicht auf den Verschlussteller mit dem Klemmstück in geschlossener Stellung;
- Fig. 6b: eine Draufsicht auf den Verschlussteller mit dem Klemmstück in offener Stellung; und
- Fig. 7: eine Draufsicht auf eine alternative Ausführungsform des Verschlusstellers mit einem Klemmstück in geschlossener Stellung.

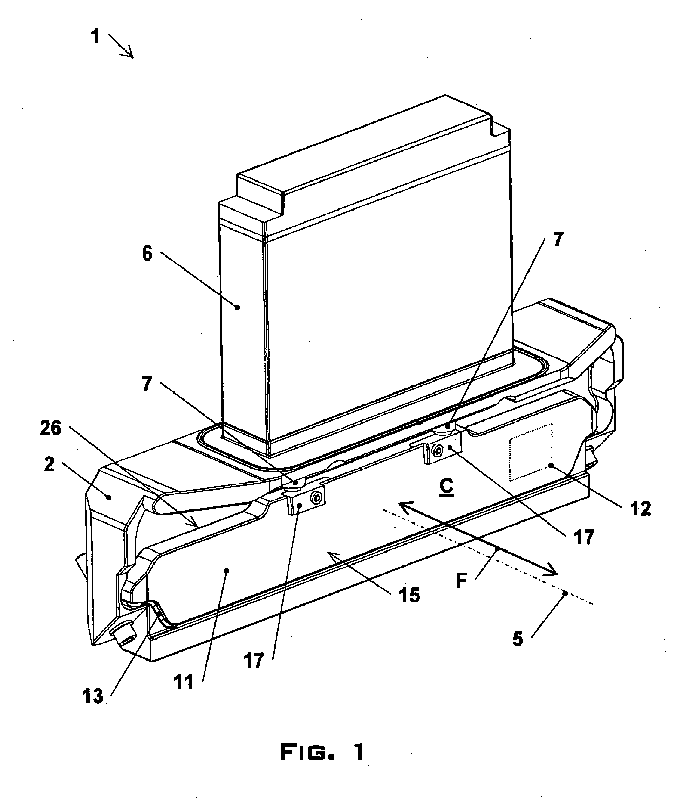

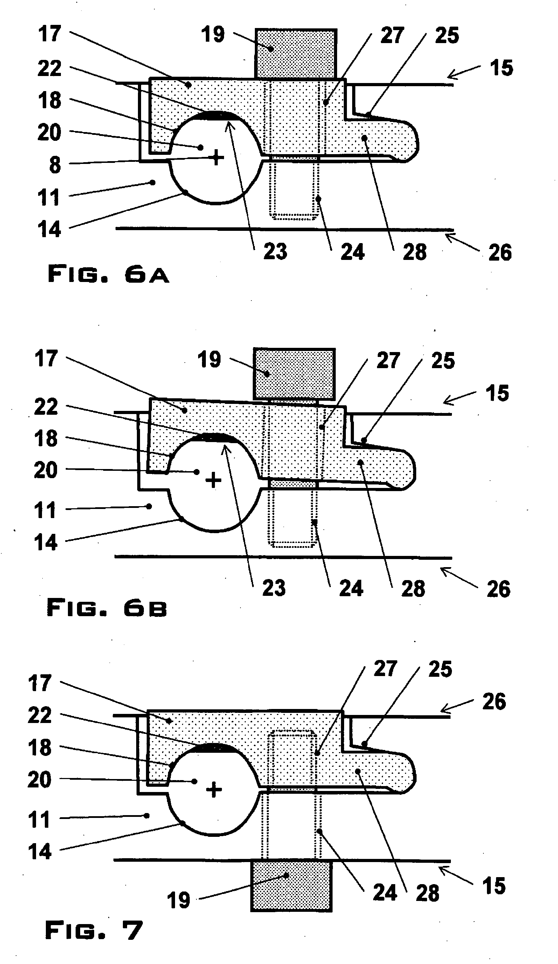

Die Figuren 1 bis 6b zeigen im Wesentlichen eine einzige beispielhafte Ausführungsform der Erfindung in unterschiedlichen Ansichten, Zuständen und Detaillierungsgraden, weshalb diese Figuren zum Teil gemeinsam beschrieben werden. Die Figur 7 zeigt eine alternative Ausführungsform des Vakuumventils in einer Detailansicht. Da für die Figuren zum Teil gemeinsame Bezugszeichen verwendet werden und sich die Ausführungsformen teilweise nur in Details unterscheiden, wird auf bereits zuvor erläuterte Bezugszeichen partiell nicht nochmals eingegangen.

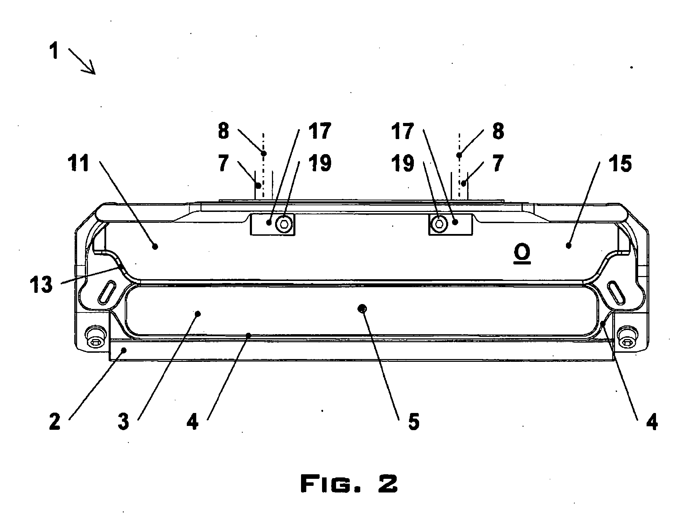

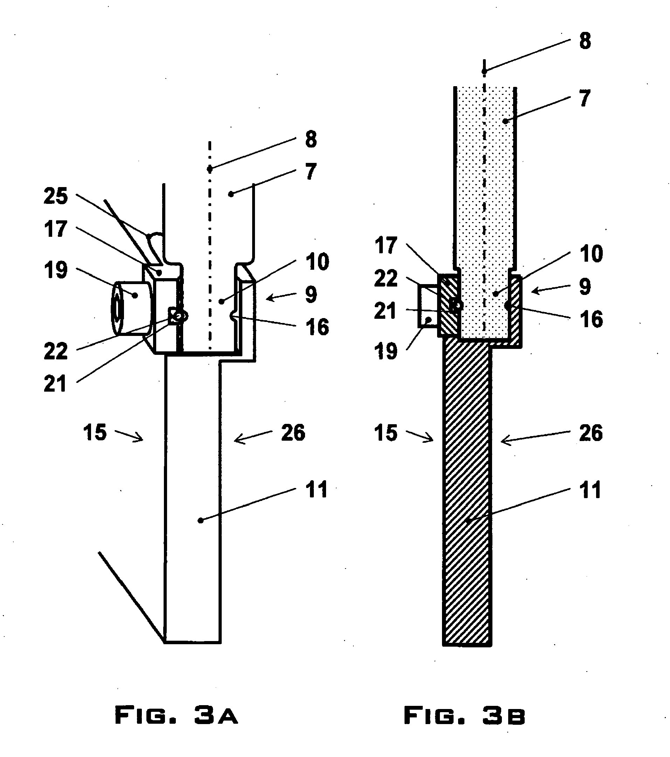

In den Figuren 1 und 2 ist ein Vakuumventil 1 in Form eines Rechteckschiebers zum gasdichten Schliessen eines mittels des Pfeils F veranschaulichten Fliesswegs in einer Schrägansicht bzw. in einer Frontansicht dargestellt. Die Figuren 3a, 3b sowie 6a und 6b zeigen den Verschlussteller 11 und dessen Bestandteile einschliesslich der Enden der Schubstangen 7 des Vakuumventils 1 aus den Figuren 1 und 2. Im Folgenden werden diese Figuren gemeinsam beschrieben.

Das Vakuumventil 1 besitzt ein Ventilgehäuse 2 mit einer Öffnung 3 für den Fliessweg F. Die Öffnung 3 hat einen recheckigen Querschnitt mit abgerundeten Ecken. Die Figur 1 zeigt das Vakuumventil 1 in einer geschlossenen Position C, weshalb die Öffnung 3 verdeckt und nicht sichtbar ist, während in der geöffneten Position O des Vakuumventils 1 in Figur 2 die Öffnung 3 deutlich erkennbar ist. Die Öffnung 3 hat eine mittlere Öffnungsachse 5, die sich im Bereich der Öffnung 3 in der Mitte des Fliesswegs F parallel zu diesem erstreckt. Diese Öffnungsachse 5 steht senkrecht auf der von der Öffnung aufgespannten gedachten Fläche. Die Öffnung 3 wird von einer Ventilsitzfläche 4 umschlossen, die sich rings um die Öffnung 3 gekrümmt innerhalb mehrerer gedachter Ebenen, die von der Öffnungsachse 4 senkrecht durchstossen werden, erstreckt. Die Ventilsitzfläche 4 weist nach oben in Richtung zum Ventilantrieb 6.

Ausserdem umfasst das Vakuumventil 1 einen flachen Verschlussteller 11. Der Verschlussteller 11 hat eine mit der Ventilsitzfläche 4 korrespondierende Verschlussfläche 13, die in Richtung zur Ventilsitzfläche 4 nach unten weist und sich ebenfalls gekrümmt innerhalb mehrerer gedachter Ebenen, die von der Öffnungsachse 5 senkrecht durchstossen werden, erstreckt.

Das Vakuumventil 1 hat zwei Schubstangen 7, die mittels des Ventilantriebs 6 entlang ihrer Schubstangenachse 8, die im Wesentlichen quer zu der Öffnungsachse 5 verläuft, linear verstellbar ist. In anderen Worten verlaufen die Schubstangenachsen 8 parallel auf einer Ebene, zu welcher die Öffnungsachse 5 eine Normale bildet.

Wie in den Figuren 3a und 3b erkennbar, besitzen die Schubstangen 7 an ihrem jeweiligen Schubstangenende 9 einen zylindrischen Verbindungsabschnitt 10. Auf den beiden Schubstangen 7 ist ein Verschlussteller 11 abnehmbar montiert, der eine Verschlusstellerebene 12 definiert. Diese gedachte Verschlusstellerebene 12 ist mittels eines Rechtecks in Figur 1 symbolisiert. Der Verschlussteller 11 hat eine Verschlussseite 26 und eine hierzu im Wesentlichen parallel gegenüberliegende Rückseite 15. Ausserdem hat er eine mit der Ventilsitzfläche 4 korrespondierende Verschlussfläche 13 zum gasdichten Schliessen des Fliesswegs F durch Herstellen eines dichtenden Kontakts der Verschlussfläche 13 mit der Ventilsitzfläche 4. Dieser Kontakt wird mittels des Ventilantriebs 6 hergestellt, indem der Verschlussteller 11 linear entlang der Schubstangenachse 8 verstellt wird und mit dessen Verschlussfläche 13 auf den Ventilsitz 4 des Ventilgehäuses 2 gedrückt wird, wie in Figur 1 gezeigt. Der Verschlussteller 11 weist mit seiner Verschlussseite 26 auf die Öffnung 3, wobei die Rückseite 15 von der Öffnung 3 weggewandt ist.

Der Ventilantrieb 6 ist derart ausgebildet, dass die Schubstange 7 mittels des Ventilantriebs 6 entlang der Schubstangenachse 8 linear verstellbar ist. Die Ventilsitzfläche 4 umschliesst die Öffnung 3 gekrümmt geschlossen. Die Flächennormalen der zumindest teilweise gekrümmten Ventilsitzfläche 4 und der Verschlussfläche 13 verlaufen im Wesentlichen parallel zu der Verschlusstellerebene 13. Der Verschlussteller 11 ist somit entlang des parallel zur Schubstangenachse 8 verlaufenden linearen Verstellwegs der beiden Schubstangen 7 zwischen einer geöffneten, die Öffnung 3 freigebenden Position O und einer gasdicht geschlossenen, über die Öffnung 3 linear geschobenen und somit mit der Verschlussfläche 13 im Wesentlichen in Schliessrichtung des linearen Verstellwegs auf die Ventilsitzfläche 4 drückenden Position C mittels des Ventilantriebs 6 linear verschiebbar.

Unter den geometrischen Flächennormalen sind die Senkrechten auf der im geschlossenen Zustand des Vakuumventils 1 rings um die Öffnung 3 verlaufenden Berührungsfläche der Ventilsitzfläche 4 und der Verschlussfläche 13 zu verstehen. Diese Berührungsfläche wird beispielsweise durch die Kontaktfläche eines Dichtungsbandes der Verschlussfläche 13 und der Ventilsitzfläche 4 gebildet. Unter dieser Definition sei allgemein zu verstehen, dass die Ventilsitzfläche 4 und die Verschlussfläche 13 derart ausgebildet sind, dass beim Schliessen des Vakuumventils 1 entlang der linearen Schliessrichtung das Drücken, also die Richtung der Druckkräfte, der Verschlussfläche 13 auf die Ventilsitzfläche 4 im Wesentlichen in einer Ebene erfolgt, die im Wesentlichen parallel zu der Verschlusstellerebene 12 verläuft, so dass Scherkräfte in eine Richtung parallel zur Öffnungsachse 5 ganz oder im Wesentlichen vermieden werden. Der lineare Verstellweg ist die Gerade zwischen der geöffneten und der geschlossenen Position O bzw. C des Verschlusstellers 11, vorzugsweise parallel zu der Schubstangenachse 8. Ein Vakuumventil mit einer derart ausgestalteten Ventilsitzfläche 4 und Verschlussfläche 13 ist im Wesentlichen aus dem Stand der Technik, beispielsweise als das unter der Produktbezeichnung "MONOVAT Reihe 02 und 03" von der Firma VAT Vakuumventile AG in Haag, Schweiz entwickelte und vertriebene Rechteckinsertventil, bekannt. Der Aufbau und die Funktionsweise eines solchen Ventils werden beispielsweise in der US 4,809,950 (Geiser) und der US 4,881,717 (Geiser) beschrieben, weshalb an dieser Stelle nicht näher auf den Aufbau eingegangen wird.

Der Verschlussteller 11 hat zwei mit dem Verbindungsabschnitt 10 korrespondierende, konkave, halbkreisförmige erste Stangenausnehmungen 14, siehe Figuren 6a und 6b, die auf einer Befestigungsseite am Verschlussteller 11 ausgeformt sind. Die Befestigungsseite wird bei dem Ausführungsbeispiel der Figuren 1 bis 6b durch die Rückseite 15 und bei dem Ausführungsbeispiel aus Figur 7 durch Verschlussseite 26 gebildet.

Mittels eines Klemmstücks 17 und eines mechanischen Fixierungselements 19 ist der jeweilige Verbindungsabschnitt 10 der Schubstangen 7 in den beiden ersten Stangenausnehmungen 14 lösbar fixiert.

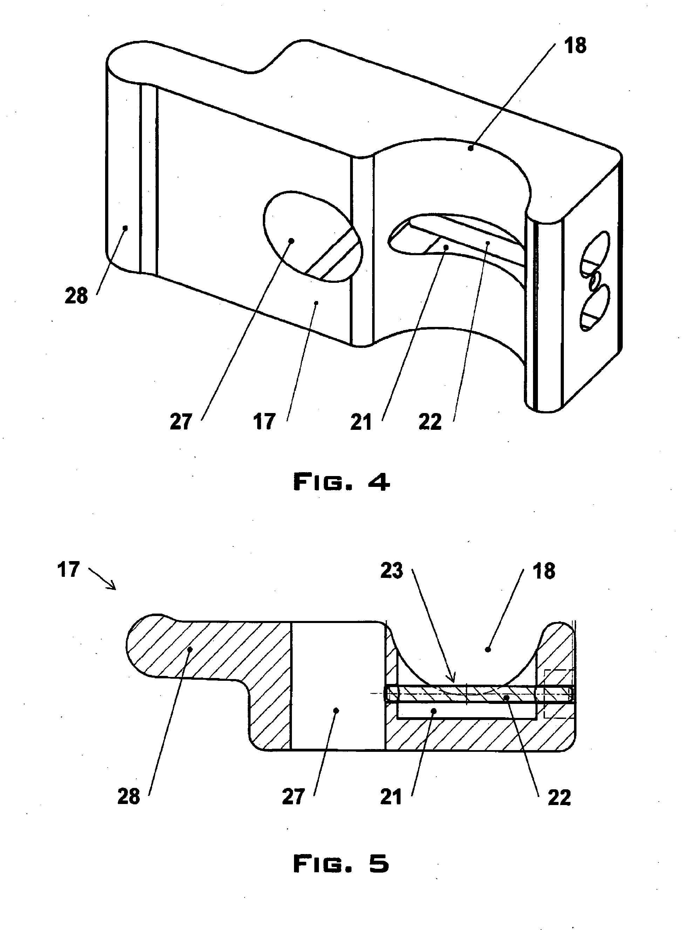

Das Klemmstück 17 besitzt eine mit dem Verbindungsabschnitt 10 korrespondierende, konkave, halbkreisförmige zweite Stangenausnehmung 18, wie in den Figuren 6a und 6b gezeigt. Mittels des mechanischen Fixierungselements 19 ist das Klemmstück 17 auf der Befestigungsseite 15 des Verschlusstellers 11 derart verstellbar montiert, dass die halbkreisförmige erste Stangenausnehmung 14 und die gegenüberliegende halbkreisförmige zweite Stangenausnehmung 18 einen weitenverstellbaren zylindrischen Aufnahmebereich 20 definieren, in welchem der zylindrische Verbindungsabschnitt 10 lösbar aufgenommen ist, wie in den Figuren 3a und 3b sowie 6a und 6b gezeigt. In der zweiten Stangenausnehmung 18, oder alternativ in der ersten Stangenausnehmung 14, ist eine sich quer zur Schubstangenachse 8 erstreckende Aussparung 21 ausgeformt, in welcher sich ein elastischer zylindrischer Bolzen 22 quer zur Schubstangenachse 8 und tangential zum zylindrischen Aufnahmebereich 20 erstreckt, wie auch in Figuren 4 und 5 im Detail gezeigt. Der elastische Bolzen 22 ragt mit seiner Seitenfläche 23 in den zylindrischen Aufnahmebereich 20 hinein. Der Bolzen 22 ist mit seinen beiden Enden in der Aussparung 21 fixiert und der mittlere unfixierte Bereich des Bolzens 22 ragt zwischen den beiden Enden in den zylindrischen Aufnahmebereich 20 hinein.

Der Verbindungsabschnitt 10 der Schubstange 7 besitzt eine quer zur Schubstangenachse 8 verlaufende, mit dem Bolzen 22 korrespondierende Fuge 16, die sich derart erstreckt, dass der Bolzen 22 mit seiner Seitenfläche 23 mittels des Klemmstücks 17 in die Fuge 16 geklemmt ist und die Schubstange 7 entlang der Schubstangenachse 8 fixiert, wie in den Figuren 3a und 3b gezeigt. Die Fuge 16 erstreckt sich rings um den Verbindungsabschnitt 10 der Schubstange 7 auf einer Ebene, zu welcher die Schubstangenachse 8 eine Normale bildet. Es ist jedoch alternativ möglich, dass die Fuge 16 nicht den gesamten Verbindungsabschnitt 10 umschliesst, sondern auf einer zum Bolzen 22 weisenden Seite des Verbindungsabschnitts 10 der Schubstange 7 ausgeformt ist. Die Fuge 16 hat einen im Wesentlichen V-förmig nach innen in die Fuge 16 verjüngenden Querschnitt, einen halbkreisförmigen Querschnitt oder einen sonstigen beliebigen Querschnitt.

Im gezeigten Ausführungsbeispiel ist die Aussparung 21 in der zweiten Stangenausnehmung 18 ausgeformt und der Bolzen 22 ist im Klemmstück 17 angeordnet. Alternativ befinden sich die Aussparung 21 und der Bolzen 22 in der ersten Stangenausnehmung 14 bzw. dem Verschlussteller 11.

Das mechanische Fixierungselement ist in den Figuren 1 bis 6b jeweils als mindestens eine sich im Wesentlichen senkrecht zur Verschlusstellerebene 12 erstreckende Schraube 19 ausgebildet. Das Klemmstück 17 ist seitlich neben der ersten Stangenausnehmung 14 mit einem Abschnitt 28 in eine derart ausgebildete Hinterschneidung 25, die auf der Befestigungsseite 15 des Verschlusstellers 11 ausgeformt ist, eingeführt, dass das Klemmstück 17 in die von dem Verschlussteller 11 wegweisende und zur Verschlusstellerebene 12 senkrechte Richtung fixiert ist. Die Schraube 19 ist in ein erstes Loch 24, das seitlich neben der ersten Stangenausnehmung 14 auf der Befestigungsseite 15 des Verschlusstellers 11 ausgeformt und sich im Wesentlichen senkrecht zu der Verschlusstellerebene 12 erstreckt, und ein korrespondierendes zweites Loch 27 im Klemmstück 17, das sich im Wesentlichen senkrecht zu der Verschlusstellerebene 12 erstreckt, angeordnet. Hierbei sind die Hinterschneidung 25, das erste Loch 24, das zweite Loch 27 und der Abschnitt 28 des Klemmstücks 17 derart angeordnet und ausgebildet, dass die Schraube 19 das Klemmstück 17 hebelartig mit der zweiten Stangenausnehmung 18 auf den Verbindungsabschnitt 10 der Schubstange 7 drückt. In der Figur 6a ist der angezogenen Zustand der Schraube 19 gezeigt, in welchem die Schubstangen 7 fest im Aufnahmebereich 20 fixiert sind, wohingegen in Figur 6b ein Zustand gezeigt ist, in welchem die Schubstangen 7 in den jeweiligen Aufnahmebereich 20 hinausgeführt und herausgeführt werden können, wobei der Bolzen 22 eine axiale Vorfixierung des Verschlusstellers 11 auf den Schubstangen 7 bewirkt.

Im ersten Ausführungsbeispiel gemäss den Figuren 1 bis 6b ist das erste Loch 24 im Verschlussteller ein Gewindeloch, in welches die Schraube 19 eingreift, und die Schraube 19 ist durch das zweite Loch 27 mit Spiel hindurchgeführt.

Im zweiten Ausführungsbeispiel gemäss Figur 7 ist hingegen das zweite Loch 27 im Klemmstück 17 ein Gewindeloch, in welches die Schraube 19 eingreift, und die Schraube 19 ist durch das erste Loch 24 mit Spiel hindurchgeführt. In beiden Fällen befindet sich der Kopf der jeweiligen Schraube 19 leicht zugänglich auf der Rückseite 15 des Verschlusstellers 11, jedoch ist das Klemmstück 17 im ersten Ausführungsbeispiel auf der Rückseite 15 und im zweiten Ausführungsbeispiel auf der Verschlussseite 26 angeordnet, so dass im ersten Fall die Rückseite 15 und im zweiten Fall die Verschlussseite 26 die Befestigungsseite ist. Die zweite Ausführungsform erfordert somit kein Gewinde im Verschlussteller 11, da das Gewinde im Klemmstück 17 ausgeformt ist. Dies ist vor allem bei einem aus Aluminium gefertigten Verschlussteller 11 von Vorteil.

Obwohl in den gezeigten Ausführungsbeispielen ein Vakuumventil 1, das mittels einer einzigen linearen Bewegung verschliessbar ist, gezeigt wird, erstreckt sich Erfindung auch auf Vakuumventile, bei welchen der Ventilantrieb 6, die Ventilsitzfläche 4 und die Verschlussfläche 13 derart ausgebildet sind, dass durch Verschieben des Verschlusstellers 11 im Wesentlichen entlang der Schubstangenachse 8 über die Öffnung 3 und Andrücken des Verschlusstellers 11 mit der Verschlussfläche 13 auf die Ventilsitzfläche 4 in senkrechter Richtung zur Verschlusstellerebene 12 die Öffnung 3 verschliessbar ist.

## Patentansprüche

1. Vakuumventil (1) zum gasdichten Schliessen eines Fliesswegs (F), mit
• einem Ventilgehäuse (2) mit einer Öffnung (3) für den Fliessweg (F) und einer die Öffnung (3) umschliessenden Ventilsitzfläche (4), wobei die Öffnung (3) eine Öffnungsachse (5) entlang des Fliesswegs (F) aufweist,
• einem Ventilantrieb (6),
• mindestens einer Schubstange (7),
□ die mittels des Ventilantriebs (6) entlang ihrer Schubstangenachse (8), die im Wesentlichen quer zu der Öffnungsachse (5) verläuft, linear verstellbar ist und
□ die am Schubstangenende (9) einen zylindrischen Verbindungsabschnitt (10) besitzt,
• einem Verschlussteller (11), der auf der mindestens einen Schubstange (7) abnehmbar montiert ist und der eine Verschlusstellerebene (12) definiert, mit
□ einer Verschlussseite (26) und einer hierzu im Wesentlichen parallel gegenüberliegenden Rückseite (15),
□ einer mit der Ventilsitzfläche (4) korrespondierenden Verschlussfläche (13) zum gasdichten Schliessen des Fliesswegs (F) durch Herstellen eines dichtenden Kontakts der Verschlussfläche (13) mit der Ventilsitzfläche (4) mittels des Ventilantriebs (6), wobei der Verschlussteller (11) mit seiner Verschlussseite (26) auf die Öffnung (3) weist und die Rückseite (15) von der Öffnung (3) weggewandt ist,
□ mindestens einer mit dem Verbindungsabschnitt (10) korrespondierenden, konkaven, halbkreisförmigen ersten Stangenausnehmung (14), die auf einer - Befestigungsseite (26; 15), welche durch die Verschlussseite (26) oder die Rückseite (15) gebildet wird, am Verschlussteller (11) ausgeformt ist,
und
• Befestigungsmitteln, mittels welcher der Verbindungsabschnitt (10) der Schubstange (7) in der ersten Stangenausnehmung (14) lösbar fixiert ist,
**dadurch gekennzeichnet, dass**
• die Befestigungsmittel als
□ ein Klemmstück (17), das eine mit dem Verbindungsabschnitt (10) korrespondierende, konkave, halbkreisförmige zweite Stangenausnehmung (18) besitzt, und
□ ein mechanisches Fixierungselement (19), mittels welchem das Klemmstück (17) auf der Befestigungsseite (26; 15) des Verschlusstellers (11) derart verstellbar montiert ist, dass die halbkreisförmige erste Stangenausnehmung (14) und die gegenüberliegende halbkreisförmige zweite Stangenausnehmung (18) einen weitenverstellbaren zylindrischen Aufnahmebereich (20) definieren, in welchem der zylindrische Verbindungsabschnitt (10) lösbar aufgenommen ist, aufgebildet sind,
wobei in der ersten Stangenausnehmung (14) oder der zweiten Stangenausnehmung (18) eine sich quer zur Schubstangenachse (8) erstreckende Aussparung (21) ausgeformt ist, in welcher sich ein elastischer Bolzen (22) quer zur Schubstangenachse (8) und tangential zum zylindrischen Aufnahmebereich (20) erstreckt, wobei der elastische Bolzen (22) mit seiner Seitenfläche (23) in den zylindrischen Aufnahmebereich (20) hineinragt, und
• der Verbindungsabschnitt (10) der Schubstange (7) eine quer zur Schubstangenachse (8) verlaufende, mit dem Bolzen (22) korrespondierende Fuge (16) besitzt, die sich derart erstreckt, dass der Bolzen (22) mit seiner Seitenfläche (23) mittels des Klemmstücks (17) in die Fuge (16) geklemmt ist und die Schubstange (7) entlang der Schubstangenachse (8) fixiert.

2. Vakuumventil nach Anspruch 1, wobei
der Bolzen (22) mit seinen beiden Enden in der Aussparung (21) fixiert ist und der mittlere unfixierte Bereich des Bolzens (22) zwischen den beiden Enden in den zylindrischen Aufnahmebereich (20) hineinragt.

3. Vakuumventil nach Anspruch 1 oder 2, wobei
sich die Fuge (16) rings um den Verbindungsabschnitt (10) der Schubstange (7) auf einer Ebene erstreckt, zu welcher die Schubstangenachse (8) eine Normale bildet.

4. Vakuumventil nach Anspruch 1 oder 2, wobei
die Fuge (16) auf einer zum Bolzen (22) weisenden Seite des Verbindungsabschnitts (10) der Schubstange (7) ausgeformt ist und sich auf einer Ebene erstreckt, zu welcher die Schubstangenachse (8) eine Normale bildet.

5. Vakuumventil nach einem der Ansprüche 1 bis 4, wobei
die Fuge (16) einen im Wesentlichen V-förmig nach innen in die Fuge (16) verjüngenden Querschnitt oder einen halbkreisförmigen Querschnitt hat.

6. Vakuumventil nach einem der Ansprüche 1 bis 5, wobei
die Aussparung (21) in der zweiten Stangenausnehmung (18) ausgeformt und der Bolzen (22) im Klemmstück (17) angeordnet ist.

7. Vakuumventil nach einem der Ansprüche 1 bis 6, wobei
• das mechanische Fixierungselement als mindestens eine sich im Wesentlichen senkrecht zur Verschlusstellerebene (12) erstreckende Schraube (19) ausgebildet ist,
• das Klemmstück (17) seitlich neben der ersten Stangenausnehmung (14) mit einem Abschnitt (28) in eine derart ausgebildete Hinterschneidung (25), die auf der Befestigungsseite (26; 15) des Verschlusstellers (11) ausgeformt ist, eingeführt ist, dass das Klemmstück (17) in die von dem Verschlussteller (11) wegweisende und zur Verschlusstellerebene (12) senkrechte Richtung fixiert ist,
• die Schraube (19) in
□ ein erstes Loch (24), das seitlich neben der ersten Stangenausnehmung (14) auf der Befestigungsseite (26; 15) des Verschlusstellers (11) ausgeformt ist und sich im Wesentlichen senkrecht zu der Verschlusstellerebene (12) erstreckt, und
□ ein korrespondierendes zweites Loch (27) im Klemmstück (17), das sich im Wesentlichen senkrecht zu der Verschlusstellerebene (12) erstreckt,
angeordnet ist, und
• die Hinterschneidung (25), das erste Loch (24), das zweite Loch (27) und der Abschnitt (28) des Klemmstücks (17) derart angeordnet und ausgebildet sind, dass die Schraube (19) das Klemmstück (17) hebelartig mit der zweiten Stangenausnehmung (18) auf den Verbindungsabschnitt (10) der Schubstange (7) drückt.

8. Vakuumventil nach Anspruch 7, wobei
das erste Loch (24) ein Gewindeloch ist, in welches die Schraube (19) eingreift, und die Schraube (19) durch das zweite Loch (27) hindurchgeführt ist.

9. Vakuumventil nach Anspruch 7, wobei
das zweite Loch (27) ein Gewindeloch ist, in welches die Schraube (19) eingreift, und die Schraube (19) durch das erste Loch (24) hindurchgeführt ist.

10. Vakuumventil nach einem der Ansprüche 1 bis 9, wobei
• der Ventilantrieb (6) derart ausgebildet ist, dass die Schubstange (7) mittels des Ventilantriebs (6) einlang der Schubstangenachse (8) linearen verstellbar ist,
• die Ventilsitzfläche (4) die Öffnung (3) gekrümmt geschlossen umschliesst,
• die Flächennormalen der zumindest teilweise gekrümmten Ventilsitzfläche (4) und der Verschlussfläche (13) im Wesentlichen parallel zu der Verschlusstellerebene (13) verlaufen und
• der Verschlussteller (11) entlang des parallel zur Schubstangenachse (8) verlaufenden linearen Verstellwegs der Schubstange (7) zwischen
□ einer geöffneten, die Öffnung (3) freigebenden Position (O) und
□ einer gasdicht geschlossenen, über die Öffnung (3) linear geschobenen und somit mit der Verschlussfläche (13) im Wesentlichen in Schliessrichtung des linearen Verstellwegs auf die Ventilsitzfläche (4) drückenden Position (C)
mittels des Ventilantriebs (6) linear verschiebbar ist.

11. Vakuumventil nach einem der Ansprüche 1 bis 9, wobei
der Ventilantrieb (6), die Ventilsitzfläche (4) und die Verschlussfläche (13) derart ausgebildet sind, dass durch
• Verschieben des Verschlusstellers (11) im Wesentlichen entlang der Schubstangenachse (8) über die Öffnung (3) und
• Andrücken des Verschlusstellers (11) mit der Verschlussfläche (13) auf die Ventilsitzfläche (4) in senkrechter Richtung zur Verschlusstellerebene (12) die Öffnung (3) verschliessbar ist.

12. Verschlussteller (11) für ein Vakuumventil (1) nach einem der Ansprüche 1 bis 11,
wobei das Vakuumventil (1) zum gasdichten Schliessen eines Fliesswegs (F) ein Ventilgehäuse (2) mit einer Öffnung (3) für den Fliessweg (F) und eine die Öffnung (3) gekrümmt geschlossen umschliessende Ventilsitzfläche (4) aufweist, mit
• einer Verschlussseite (26) und einer hierzu im Wesentlichen parallel gegenüberliegenden Rückseite (15),
• einer Verschlussfläche (13), die mit der Ventilsitzfläche (4) des Vakuumventils (1) korrespondiert, wobei die Flächennormalen der zumindest teilweise gekrümmten Verschlussfläche (13) und der Ventilsitzfläche (4) im Wesentlichen parallel zu einer von dem Verschlussteller (11) definierten Verschlusstellerebene (12) verlaufen und die Verschlussfläche (13) derart ausgebildet ist, dass die Verschlussfläche (13) in Schliessrichtung des parallel zur Schubstangenachse (8) verlaufenden Verstellwegs auf die Ventilsitzfläche (4) in eine gasdicht geschlossene, über die Öffnung (3) linear geschobene Position (C) drückbar ist,
• mindestens einer konkaven, halbkreisförmigen ersten Stangenausnehmung (14),
□ die auf einer Befestigungsseite (26; 15), welche durch die Verschlussseite (26) oder die Rückseite (15) gebildet wird, am Verschlussteller (11) ausgeformt ist, und
□ die mit einem zylindrischen Verbindungsabschnitt (10) eines Schubstangenendes (9) mindestens einer Schubstange (7), die mittels eines Ventilantriebs (6) entlang ihrer Schubstangenachse (8), die im Wesentlichen quer zu der Öffnungsachse (5) verläuft, linear verstellbar ist, korrespondiert, wobei die Schubstangenachse (8) im Wesentlichen parallel zur Verschlusstellerebene (12) verläuft,
und
• Befestigungsmitteln, mittels welcher der Verbindungsabschnitt (10) der Schubstange (7) in der ersten Stangenausnehmung (14) lösbar fixierbar ist,
**dadurch gekennzeichnet, dass**
• die Befestigungsmittel als
□ ein Klemmstück (17), das eine mit dem Verbindungsabschnitt (10) korrespondierende, konkave, halbkreisförmige zweite Stangenausnehmung (18) besitzt, und
□ ein mechanisches Fixierungselement (19), mittels welchem das Klemmstück (17) auf der Befestigungsseite (26; 15) des Verschlusstellers (11) derart verstellbar montiert ist, dass die halbkreisförmige erste Stangenausnehmung (14) und die gegenüberliegende halbkreisförmige zweite Stangenausnehmung (18) einen weitenverstellbaren zylindrischen Aufnahmebereich (20) definieren, in welchem der zylindrische Verbindungsabschnitt (10) lösbar aufnehmbar ist, aufgebildet sind,
wobei in der ersten Stangenausnehmung (14) oder der zweiten Stangenausnehmung (18) eine sich quer zur Schubstangenachse (8) erstreckende Aussparung (21) ausgeformt ist, in welcher sich ein elastischer Bolzen (22) quer zur Schubstangenachse (8) und tangential zum zylindrischen Aufnahmebereich (20) erstreckt, wobei der elastische Bolzen (22) mit seiner Seitenfläche (23) in den zylindrischen Aufnahmebereich (20) derart hineinragt, dass der Bolzen (22) mit seiner Seitenfläche (23) mittels des Klemmstücks (17) in eine Fuge (16), die im Verbindungsabschnitt (10) der Schubstange (7) quer zur Schubstangenachse (8) verläuft und mit dem Bolzen (22) korrespondiert, klemmbar ist und die Schubstange (7) entlang der Schubstangenachse (8) fixierbar ist.

13. Verschlussteller (11) nach Anspruch 12, wobei
der Bolzen (22) mit seinen beiden Enden in der Aussparung (21) fixiert ist und der mittlere unfixierte Bereich des Bolzens (22) zwischen den beiden Enden in den zylindrischen Aufnahmebereich (20) hineinragt.

14. Verschlussteller (11) nach Anspruch 12 oder 13, wobei
die Aussparung (21) in der zweiten Stangenausnehmung (18) ausgeformt und der Bolzen (22) im Klemmstück (17) angeordnet ist.

15. Verschlussteller (11) nach einem der Ansprüche 12 bis 14,
wobei
• das mechanische Fixierungselement als mindestens eine sich im Wesentlichen senkrecht zur Verschlusstellerebene (12) erstreckende Schraube (19) ausgebildet ist,
• das Klemmstück (17) seitlich neben der ersten Stangenausnehmung (14) in eine derart ausgebildete Hinterschneidung (25), die auf der Befestigungsseite (26; 15) des Verschlusstellers (11) ausgeformt ist, eingeführt ist, dass das Klemmstück (17) in die von dem Verschlussteller (11) wegweisende und zur Verschlusstellerebene (12) senkrechte Richtung fixiert ist,
• die Schraube (19) in
□ einer ersten Bohrung (24), die seitlich neben der ersten Stangenausnehmung (14) auf der Befestigungsseite (26; 15) des Verschlusstellers (11) ausgeformt ist und sich im Wesentlichen senkrecht zu der Verschlusstellerebene (12) erstreckt, und
□ einer korrespondierenden zweiten Bohrung (27) im Klemmstück (17), die sich im Wesentlichen senkrecht zu der Verschlusstellerebene (12) erstreckt,
angeordnet ist, und
• die Hinterschneidung (25), die erste Bohrung (24), die zweite Bohrung (27) und das Klemmstück (17) derart angeordnet und ausgebildet sind, dass das Klemmstück (17) mittels der Schraube (19) hebelartig mit der zweiten Stangenausnehmung (18) auf den Verbindungsabschnitt (10) der Schubstange (7) drückbar ist.
